(19) Europäisches Patentamt / European Patent Office / Office européen des brevets

(11) **EP 4 194 487 A1**

(12) **EUROPEAN PATENT APPLICATION**
published in accordance with Art. 153(4) EPC

(43) Date of publication:
**14.06.2023 Bulletin 2023/24**

(21) Application number: **21852926.1**

(22) Date of filing: **30.07.2021**

(51) International Patent Classification (IPC):
**C08J 5/18** (2006.01)   **C08L 27/12** (2006.01)
**C08L 71/10** (2006.01)   **H01B 3/42** (2006.01)
**H05K 1/03** (2006.01)

(52) Cooperative Patent Classification (CPC):
**C08J 5/18; C08L 27/12; C08L 27/18; C08L 71/10;
H01B 3/42; H05K 1/03**

(86) International application number:
**PCT/JP2021/028459**

(87) International publication number:
**WO 2022/030410 (10.02.2022 Gazette 2022/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **07.08.2020   JP 2020135054**

(71) Applicant: **Daikin Industries, Ltd.
Osaka-shi, Osaka 530-8323 (JP)**

(72) Inventors:
• **SEKI, Toyomitsu
  Osaka-Shi, Osaka 530-8323 (JP)**
• **MARUHASHI, Takuma
  Osaka-Shi, Osaka 530-8323 (JP)**
• **NAKANISHI, Koji
  Osaka-Shi, Osaka 530-8323 (JP)**
• **KONO, Hideki
  Osaka-Shi, Osaka 530-8323 (JP)**

(74) Representative: **Hoffmann Eitle
Patent- und Rechtsanwälte PartmbB
Arabellastraße 30
81925 München (DE)**

(54) **FILM, WRAPPING ELECTRIC WIRE COATING MATERIAL, FILM FOR FLEXIBLE PRINTED CIRCUIT BOARD, AND LAMINATE**

(57)   Provided are a film having excellent flexibility, excellent bending resistance, and excellently low dielectricity while maintaining the properties of the aromatic polyetherketone resin (I), as well as a wrapping electric wire coating material, a film for a flexible printed circuit board, and a laminate each including the former film. The film contains a resin composition containing an aromatic polyetherketone resin (I) and a fluorine-containing copolymer (II). The fluorine-containing copolymer (II) defines a dispersed phase at an average dispersed particle size of 5 um or smaller. The aromatic polyetherketone resin (I) has a crystallinity of lower than 6%.

**EP 4 194 487 A1**

**Description**

TECHNICAL FIELD

The disclosure relates to films, wrapping electric wire coating materials, films for flexible printed circuit boards, and laminates.

BACKGROUND ART

Engineering plastics such as aromatic polyetherketone resin are thermoplastic resins having high heat resistance, high-level mechanical strength, and high-level dimensional stability and are therefore used for a variety of applications.

Fluororesins are excellent in properties such as slidability, heat resistance, chemical resistance, solvent resistance, weather resistance, flexibility, and electrical properties and are used in a wide variety of fields such as automobiles, industrial machinery, OA equipment, and electric or electronic devices. However, many fluororesins are poor in physical heat resistance as indicated by mechanical properties or heat deflection temperature in comparison with crystalline heat-resistant thermoplastic resins. Also, some fluororesins are poor in dimensional stability in comparison with amorphous heat-resistant thermoplastic resins. These features limit the range of applications of fluororesins in practical use.

The above situation promotes studies on techniques for combination use of thermoplastic resin and fluororesin. For example, Patent Literature 1 discloses a film containing an aromatic polyetherketone resin (I) and a fluororesin (II) wherein the aromatic polyetherketone resin (I) has a crystallinity of 10% or higher.

Patent Literature 2 discloses a polyarylketone film containing a resin composition containing 100 parts by weight of a polyarylketone and 3 to 30 parts by weight of a different thermoplastic resin, wherein the film has a cushion percentage of 3 to 30% and is stretched in at least one direction.

Patent Literature 3 discloses a resin composition containing (A) 70 to 99% by mass of a polyarylketone resin and (B) 30 to 1% by mass of a fluororesin, wherein the fluororesin (B) dispersed in the resin composition has an average particle size of 0.1 to 30 um.

Patent Literature 4 discloses a resin composition containing a polyaryletherketone and a fluorine-containing elastomer, wherein the ratio ($MFR_A/MFR_B$) of the melt flow rate $MFR_A$ of the polyaryletherketone at a temperature of 372°C under a load of 49 N to the melt flow rate $MFR_B$ of the fluorine-containing elastomer at a temperature of 372°C under a load of 49 N is from 0.2 to 5.0, and the proportion of the volume of the polyaryletherketone in the sum of the volume of the polyaryletherketone and the volume of the fluorine-containing elastomer is from 60 to 97 vol%.

CITATION LIST

- Patent Literature

Patent Literature 1: JP 2016-29164 A
Patent Literature 2: JP 2003-82123 A
Patent Literature 3: JP 2006-274073 A
Patent Literature 4: WO 2019/198771

SUMMARY OF INVENTION

- Technical Problem

Patent Literature 1 aims to provide a film having excellent mechanical strength and excellent abrasion resistance. Patent Literature 2 aims to provide a film having a high Young's modulus, a low permittivity, excellent incombustibility, excellent heat resistance, excellent insulation, and high rigidity. Patent Literature 3 aims to provide a relatively thin resin molded article, such as a film or a sheet, having good appearance, a small unevenness in the thickness, excellent slidability, excellent solvent resistance, and excellent heat resistance. Patent Literature 4 aims to provide a molded article having excellent impact resistance, excellent flexibility, excellent bending resistance, and less appearance failure without losing the properties of the polyaryletherketone.

No conventional films formed from a resin composition containing an aromatic polyetherketone resin (I) and a fluorine-containing copolymer (II) successfully have excellent flexibility, excellent bending resistance, and excellently low dielectricity while maintaining the properties of the aromatic polyetherketone resin (I).

The disclosure is made in view of the above current state of the art and aims to provide a film having excellent flexibility, excellent bending resistance, and excellently low dielectricity while maintaining the properties of the aromatic polyetherketone resin (I), as well as a wrapping electric wire coating material, a film for a flexible printed circuit board, and a laminate each including the film.

- Solution to Problem

The disclosers examined a film having excellent flexibility, excellent bending resistance, and excellently low dielectricity while maintaining the properties of the aromatic polyetherketone resin (I), and focused on the crystallinity of the aromatic polyetherketone resin (I), the average dispersed particle size of the fluorine-containing copolymer, and the ratio of the dispersed particle sizes before and after molding. The disclosers then found that the presence of an aromatic polyetherketone resin (I) having a crystallinity within a predetermined range and a fluorine-containing copolymer (II) having an average dispersed particle size within a predetermined range or a fluorine-containing copolymer (II) having a ratio of dispersed particle sizes within a predetermined range can lead to a film having excellent flexibility, excellent bending resistance, and excellently low dielectricity while maintaining the properties of the aromatic polyetherketone resin (I).

In other words, the disclosure relates to a film containing a resin composition comprising an aromatic polyetherketone resin (I) and a fluorine-containing copolymer (II), the fluorine-containing copolymer (II) defining a dispersed phase at an average dispersed particle size of 5.0 um or smaller, the aromatic polyetherketone resin (I) having a crystallinity of lower than 6% (hereinafter, also referred to as a "first film of the disclosure").

Preferably, the first film of the disclosure satisfies a ratio r2/r1 of 1.60 or lower, wherein r1 represents the average dispersed particle size of the fluorine-containing copolymer (II) and r2 represents an average dispersed particle size of the fluorine-containing copolymer (II) after melt flow rate measurement at 380°C and a 5000-g load with 5-minute pre-heating in conformity with ASTM D1238.

The disclosure also relates to a film containing a resin composition containing an aromatic polyetherketone resin (I) and a fluorine-containing copolymer (II), the film satisfying a ratio r2/r1 of 1.60 or lower, wherein r1 represents an average dispersed particle size of the fluorine-containing copolymer (II) and r2 represents an average dispersed particle size of the fluorine-containing copolymer (II) after melt flow rate measurement at 380°C and a 5000-g load with 5-minute pre-heating in conformity with ASTM D1238 (hereinafter, also referred to as a "second film of the disclosure").

The term "film of the disclosure" used herein generally encompasses both the first and second films of the disclosure.

Preferably, the film of the disclosure has a tensile modulus of 2400 MPa or lower.

Preferably, the film of the disclosure has a fold number of 2000 times or more determined using an MIT folding tester.

Preferably, the aromatic polyetherketone resin (I) has a melting point of 300°C to 380°C.

Preferably, the aromatic polyetherketone resin (I) has a glass transition temperature of 130°C to 220°C.

Preferably, the fluorine-containing copolymer (II) has a melting point of 200°C to 323°C.

Preferably, the fluorine-containing copolymer (II) is a copolymer of tetrafluoroethylene and a perfluoroethylenic unsaturated compound represented by the following formula (1) :

$$CF_2=CF-Rf^1 \qquad (1)$$

wherein $Rf^1$ is $-CF_3$ or $-ORf^2$, where $Rf^2$ is a C1-C5 perfluoroalkyl group.

Preferably, the film of the disclosure satisfies that the aromatic polyetherketone resin (I) and the fluorine-containing copolymer (II) have a mass ratio (I):(II) of 99:1 to 30:70.

The disclosure also relates to a wrapping electric wire coating material including the film of the disclosure.

The disclosure also relates to a film for a flexible printed circuit board, including the film of the disclosure.

The disclosure also relates to a laminate including the film of the disclosure.

- Advantageous Effects of Invention

The film of the disclosure has any of the aforementioned structures and therefore has excellent flexibility, excellent bending resistance, and excellently low dielectricity while maintaining the properties of the aromatic polyetherketone resin (I).

DESCRIPTION OF EMBODIMENTS

The first film of the disclosure is a film containing a resin composition containing an aromatic polyetherketone resin (I) and a fluorine-containing copolymer (II), the fluorine-containing copolymer (II) defining a dispersed phase at an average dispersed particle size of 5.0 um or smaller, the aromatic polyetherketone resin (I) having a crystallinity of lower than 6%.

The polyetherketone resin (I) is a crystalline resin. A higher crystallinity causes a higher elastic modulus and lower flexibility. In common cases, a higher elastic modulus causes a higher edge stress, which causes lower bending resistance. The disclosers performed studies to solve the above issues and found that a crystallinity of lower than 6% leads to greatly improved flexibility and greatly improved bending resistance.

A fluorine-containing copolymer (II) having poor dispersibility causes reduced tensile elongation and reduced bending resistance. Nevertheless, the disclosers also found that a fluorine-containing copolymer (II) having an average dispersed particle size of 5.0 um or smaller leads to improved tensile elongation and improved bending resistance.

In the first film of the disclosure, the aromatic polyetherketone resin (I) has a crystallinity of lower than 6%. A crystallinity of lower than 6% leads to all of flexibility, bending resistance, and low dielectricity. The crystallinity is preferably 5% or lower, more preferably 4% or lower, particularly preferably lower than 3%, most preferably 0%.

A film in which the aromatic polyetherketone resin (I) has a crystallinity of lower than 6% is obtainable by the use of a polyetherketoneketone resin. In the case of using a resin (I) other than a polyetherketoneketone resin, this film is obtainable by setting the roll temperature to the glass transition temperature or lower for rapid cooling, for example.

The crystallinity refers to the crystallinity of the aromatic polyetherketone resin (I) in the film and does not refer to the crystallinity of the aromatic polyetherketone resin (I) as a material. The crystallinity is obtainable by determining the wide angle X-ray diffraction at a scanning angle ranging from 5 to 40 degrees using an X-ray diffractometer, followed by calculation with the following formula.

$$\text{Crystallinity (\%)} = 100 \times \text{(peak area derived from crystal of aromatic polyetherketone resin (I))/(whole peak area)}$$

Specifically, Ultima III X-ray diffractometer available from Rigaku Corp. is used to determine the wide angle X-ray diffraction at an output of 40 kV-40 mA and a scanning angle ranging from 5 to 40 degrees. Analysis software JADE6.0 available from Rigaku Corp. is used to calculate the peak area derived from the crystal of the aromatic polyetherketone resin (I) and the whole peak area. The crystallinity can be then determined by the above formula.

The whole peak area is the area obtained by integrating all diffraction intensities measured at scanning angles ranging from 5 to 40 degrees (excluding the peak area derived from the crystal of the fluorine-containing copolymer (II)). The peak area derived from the crystal of the fluorine-containing copolymer (II) may be, for example, the area of the peak observed around 2Θ = 17.7 degrees.

The peak area derived from the crystal of the aromatic polyetherketone resin (I) is the sum of the areas of the peaks derived from the crystal of the aromatic polyetherketone resin (I).

The peaks derived from the crystal of the aromatic polyetherketone resin (I) vary according to the type thereof. For example, in the case where the aromatic polyetherketone resin (I) is polyetherketoneketone (PEKK), the peak area derived from the crystal of PEKK is the sum of the areas of the peaks observed around 2Θ = 15.7 degrees, 18.5 degrees, 20.4 degrees, 22.7 degrees, and 28.5 degrees. The peak observed around 2Θ = 15.7 degrees is presumed to be a peak derived from the (020) plane. The peak observed around 2Θ = 18.5 degrees is presumed to be a peak derived from the (110) plane. The peak observed around 2Θ = 20.4 degrees is presumed to be a peak derived from the (111) plane. The peak observed around 2Θ = 22.7 degrees is presumed to be a peak derived from the (200) plane. The peak observed around 2Θ = 28.5 degrees is presumed to be a peak derived from the (211) plane.

In the case where the aromatic polyetherketone resin (I) is polyetheretherketone (PEEK), the peak area derived from the crystal of PEEK is the sum of the areas of the peaks observed around 2Θ = 18.7 degrees, 20.4 degrees, 22.3 degrees, and 28.6 degrees. The peak observed around 2Θ = 18.7 degrees is presumed to be a peak derived from the (110) plane. The peak observed around 2Θ = 20.4 degrees is presumed to be a peak derived from the (111) plane. The peak observed around 2Θ = 22.3 degrees is presumed to be a peak derived from the (200) plane. The peak observed around 2Θ = 28.6 degrees is presumed to be a peak derived from the (211) plane.

In the first film of the disclosure, the fluorine-containing copolymer (II) defines a dispersed phase at an average dispersed particle size of 5.0 um or smaller. An average dispersed particle size within this range can lead to a film having excellent flexibility and excellent bending resistance. In order to provide a film having much better properties and to achieve much better moldability, the average dispersed particle size is preferably 4.0 um or smaller, more preferably 3.0 um or smaller, still more preferably 2.5 um or smaller, further more preferably 2.0 um or smaller, particularly preferably 1.5 um or smaller. The lower limit of the average dispersed particle size may be, but is not limited to, 0.01 um. An average dispersed particle size of greater than 5.0 um may cause reduced processability and reduced bending resistance.

In the first film of the disclosure, the fluorine-containing copolymer (II) preferably has a maximum dispersed particle size of 10.0 um or smaller. A maximum dispersed particle size of 10.0 um or smaller can lead to a film having excellent flexibility and excellent bending resistance. A maximum dispersed particle size of 5.0 um or smaller can lead to a film having much better flexibility and much better bending resistance. The lower limit of the maximum dispersed particle size may be, but is not limited to, 0.01 um. A maximum dispersed particle size of greater than 10.0 um may cause reduced processability and reduced bending resistance.

The average dispersed particle size and the maximum dispersed particle size of the fluorine-containing copolymer (II) in the film of the disclosure are determined by the following procedure. The average dispersed particle size of the fluorine-containing copolymer in the film can be determined as follows: the film is cut in the direction perpendicular to the extrusion direction; and the cross section is observed using a confocal laser microscope. The resulting micrograph is analyzed using image analysis software (Image J). The dispersed phases are selected and the equivalent circle diameters are measured. The equivalent circle diameters of 20 dispersed phases are calculated and averaged to determine the average dispersed particle size.

Preferably, the first film of the disclosure satisfies a ratio r2/r1 of 1.60 or lower, wherein r1 represents the average dispersed particle size of the fluorine-containing copolymer (II) and r2 represents the average dispersed particle size of the fluorine-containing copolymer (II) after melt flow rate (MFR) measurement at 380°C and a 5000-g load with 5-minute pre-heating in conformity with ASTM D1238. In order to achieve much better flexibility, much better bending resistance, and much lower dielectricity, the r2/r1 ratio is more preferably 1.50 or lower, still more preferably 1.47 or lower.

The r2/r1 ratio becomes high as dispersed particles of the fluorine-containing copolymer (II) agglomerate in the MFR measurement to form coarse particles of the fluorine-containing copolymer (II). Thus, an r2/r1 ratio of 1.60 or lower indicates that the particles of the fluorine-containing copolymer (II) less easily agglomerate in the MFR measurement.

The first film of the disclosure can be produced by a production method including molding the resin composition containing the aromatic polyetherketone resin (I) and the fluorine-containing copolymer (II) into a film.

The resin composition may be produced under common conditions using a mixer commonly used for preparing a molding composition, such as a blending mill, a Banbury mixer, a pressure kneader, or an extruder. In order to allow the fluorine-containing copolymer (II) to have a small average dispersed particle size, the mixer is preferably a twin-screw extruder, and the twin-screw extruder preferably has a screw structure with L/D = 35 or higher, more preferably L/D = 40 or higher, particularly preferably L/D = 45 or higher. The L/D means the ratio of effective screw length (L)/screw diameter (D).

Accordingly, the resin composition is preferably one obtainable by mixing the aromatic polyetherketone resin (I) and the fluorine-containing copolymer (II) using a twin-screw extruder having a screw structure with L/D = 35 or higher.

The resin composition may be produced by, for example, a method of mixing the aromatic polyetherketone resin (I) and the fluorine-containing copolymer (II) in a molten state.

Sufficiently kneading the aromatic polyetherketone resin (I) and the fluorine-containing copolymer (II) can provide a resin composition having a desired dispersed state. The dispersed state has an influence on the mechanical strength and bending resistance of the film as well as the moldability, and thus the kneading method is to be selected as appropriate so as to achieve a desired dispersed state in the film obtained from the resin composition.

An example of a method for producing the resin composition is a method in which the aromatic polyetherketone resin (I) and the fluorine-containing copolymer (II) are put into a mixer at an appropriate ratio, optionally together with any of the aforementioned different components, and the components are melt-kneaded at a temperature not lower than the melting points of the resins (I) and (II).

The different component(s) may be added to and mixed with the aromatic polyetherketone resin (I) and the fluorine-containing copolymer (II) in advance, or may be added when the aromatic polyetherketone resin (I) and the fluorine-containing copolymer (II) are blended with each other.

The temperature during the melt-kneading may be set as appropriate in accordance with factors such as the types of the aromatic polyetherketone resin (I) and the fluorine-containing copolymer (II) used, and is preferably 340°C to 400°C, for example. The kneading duration is commonly 1 to 30 minutes.

The first film of the disclosure is obtainable by molding the resin composition obtained by the melt-kneading. The kneaded article may be molded by, for example, melt extrusion molding, calender molding, press molding, or casting in accordance with the type, use, shape, and the like of the target film. In order to provide a uniform thin film, melt extrusion molding is preferred.

Melt extrusion molding may be performed using a T-die film molding machine by, for example, melting the resin composition, ejecting a film in a molten state through the die, and winding the film on a cooling roll, if necessary. The cylinder temperature of the T-die film molding machine may be set within a range where the resin composition melts. For example, the molding may be performed at 340°C to 400°C.

In production of the first film of the disclosure, the cooling roll is preferably set at a temperature of 10°C to 160°C, more preferably 25°C to 160°C. A cooling roll set at a temperature higher than 160°C may fail to reduce the crystallinity of the film. The duration in which the molten film ejected through the die is in contact with the cooling roll may be adjusted within a range from 1 to 30 seconds, for example.

The molding in production of the first film of the disclosure is preferably not followed by heating at 160°C or higher. Heating at 160°C or higher after the molding may cause crystallization of the aromatic polyetherketone resin (I) up to a crystallinity of 6% or higher, which may cause a failure in achieving the desired properties.

The second film of the disclosure contains a resin composition containing an aromatic polyetherketone resin (I) and a fluorine-containing copolymer (II), the film satisfying a ratio r2/r1 of 1.60 or lower, wherein r1 represents the average dispersed particle size of the fluorine-containing copolymer (II) and r2 represents the average dispersed particle size of the fluorine-containing copolymer (II) after melt flow rate measurement at 380°C and a 5000-g load with 5-minute pre-heating in conformity with ASTM D1238. In order to achieve much better flexibility, much better bending resistance, and much lower dielectricity, the r2/r1 ratio is more preferably 1.50 or lower, still more preferably 1.47 or lower.

In the second film of the disclosure, the aromatic polyetherketone resin (I) preferably has a crystallinity of lower than 6%. A crystallinity of lower than 6% can lead to much improved flexibility, much improved bending resistance, and much improved low dielectricity. The crystallinity is more preferably 5% or lower, still more preferably 4% or lower, particularly preferably lower than 3%, most preferably 0%.

In the second film of the disclosure, the fluorine-containing copolymer (II) preferably defines a dispersed phase at an average dispersed particle size of 5.0 um or smaller. An average dispersed particle size within this range can lead to a film having much better flexibility and much better bending resistance. In order to provide a film having much better properties and to achieve much better moldability, the average dispersed particle size is preferably 4.0 um or smaller, more preferably 3.0 um or smaller, still more preferably 2.5 um or smaller, further more preferably 2.0 um or smaller, particularly preferably 1.5 um or smaller. The lower limit of the average dispersed particle size may be, but is not limited to, 0.01 um. An average dispersed particle size of greater than 5.0 um may cause reduced processibility and reduced bending resistance.

In the second film of the disclosure, the fluorine-containing copolymer (II) preferably has a maximum dispersed particle size of 10.0 um or smaller. A maximum dispersed particle size of 10.0 um or smaller can lead to a film having excellent flexibility and excellent bending resistance. A maximum dispersed particle size of 5.0 um or smaller can lead to a film having much better flexibility and much better bending resistance. The lower limit of the maximum dispersed particle size may be, but is not limited to, 0.01 um. A maximum dispersed particle size of greater than 10.0 um may cause reduced processibility and reduced bending resistance.

The film of the disclosure can be produced by a production method including melt-kneading the aromatic polyetherketone resin (I) and the fluorine-containing copolymer (II) with a high shear force applied thereto. Specifically, the melt-kneading is performed at a shear rate of 600 sec$^{-1}$ (/sec) or higher.

The shear rate is more preferably 700 sec$^{-1}$ (/sec) or higher, still more preferably 750 sec$^{-1}$ (/sec) or higher, particularly preferably 800 sec$^{-1}$ (/sec) or higher. This allows the fluorine-containing copolymer (II) to be dispersed in the submicron order in the aromatic polyetherketone resin (I) and can reduce the agglomerating behavior of the fluorine-containing copolymer (II) during molding. As a result, the composition of the aromatic polyetherketone resin (I) and the fluorine-containing copolymer (II) obtained by melt-kneading has much better fluidity and has an r2/r1 ratio of 1.60 or lower, and can provide a film having much better tensile properties, much better flexibility, and much better impact resistance.

The shear rate ($\gamma$) is a value determined using the following formula, for example.

$$\gamma = \pi D r / C$$

D: screw outer diameter (mm)
r: screw rotation speed (rps)
C: tip clearance (mm)

The melt-kneading is preferably performed with a high shear force applied to the aromatic polyetherketone resin (I) and the fluorine-containing copolymer (II). The melt-kneading may be performed using any device and, under kneading conditions arranged for more effective application of shear force, such as the use of a special screw, a high rotation speed, and a narrow clearance, can be performed using any conventionally known device such as a twin-screw extruder, a single-screw extruder, a multi-screw extruder, a roll kneader such as a tandem extruder or a batch kneader, a Labo Plastomill, a Banbury mixer, a pressurizing kneader, or a blending mill. This allows the fluorine-containing copolymer (II) to be dispersed in the submicron order in the aromatic polyetherketone resin (I) and can reduce the agglomerating behavior of the fluorine-containing copolymer (II) during molding. This results in a film that does not suffer peeling of the surface and that has much better tensile properties, much better flexibility, much better impact resistance, and much lower dielectricity. In order to apply a high shear force, the melt-kneading is preferably performed using a twin-screw extruder or a high shear processor (reflux high shear processor) including a kneading section provided with an internal return screw.

The internal return screw is a screw provided with a return hole along the central axis of the screw from the tip toward the back end. In a high shear processor including a kneading section provided with an internal return screw, a molten resin is charged into the kneading section and sent toward the tip along with the rotation of the internal return screw, flows into the return hole through an inlet on the tip to the back side and is ejected through an outlet, and is again sent toward the tip along with the rotation of the internal return screw, thereby completing circulation. This circulation can highly disperse and mix the molten resin and reduce the size of the dispersed phase. Examples of the high shear processor include devices disclosed in JP 2005-313608 A and JP 2011-046103 A.

In the case where a twin-screw extruder is used as a kneader, a twin-screw extruder having a large L/D screw structure is preferably used. The screw structure of the twin-screw extruder preferably has L/D = 30 or higher, more preferably L/D = 35 or higher, still more preferably L/D = 40 or higher. The L/D means (effective screw length (L))/(screw diameter (D)). In order to improve the kneading performance and the productivity, the melt-kneading is most preferably performed using a twin-screw extruder.

The duration of the melt-kneading is preferably 1 to 600 sec, more preferably 5 to 300 sec. A melt-kneading duration longer than the above duration may cause significant degradation of the resin and may cause a failure in achieving the desired performance. A melt-kneading duration shorter than the above duration may cause poor dispersibility and may cause a failure in achieving the desired performance.

The temperature of the melt-kneading is not lower than the melting point of the aromatic polyetherketone resin (I) as well as not lower than the melting point of the fluorine-containing copolymer (II), and is preferably 240°C to 450°C, more preferably 260°C to 400°C.

(I) Aromatic polyetherketone resin

Use of the aromatic polyetherketone resin (I) allows the film of the disclosure to have excellent flexibility, excellent bending resistance, and excellently low dielectricity.

The aromatic polyetherketone resin (I) may be any one containing a repeating unit containing an arylene group, an ether group (-O-), and a carbonyl group (-C(=O)-), and may contain, for example, any of the repeating units represented by the following formulas (a1) to (a5):

$$[-Ar-O-Ar-C(=O)-] \qquad (a1);$$

$$[-Ar-O-Ar-C(=O)-Ar-C(=O)-] \qquad (a2);$$

$$[-Ar-O-Ar-O-Ar-C(=O)-] \qquad (a3);$$

$$[-Ar-O-Ar-C(=O)-Ar-O-Ar-C(=O)-Ar-C(=O)-] \qquad (a4);$$

and

$$[-Ar-O-Ar-O-Ar-C(=O)-Ar-C(=O)-] \qquad (a5),$$

wherein Ar is a divalent aromatic hydrocarbon ring group optionally containing a substituent.

Examples of the divalent aromatic hydrocarbon ring group represented by Ar include: C6-C10 arylene groups such as phenylene groups, including an o-, m-, or p-phenylene group, and a naphthylene group; biarylene groups such as biphenylene groups, including a 2,2'-biphenylene group, a 3,3'-biphenylene group, and a 4,4'-biphenylene group, where each arylene group has a carbon number of 6 to 10; and terarylene groups such as an o-, m-, or p-terphenylene group, where each arylene group has a carbon number of 6 to 10. These aromatic hydrocarbon ring groups may have any substituent such as a halogen atom, an alkyl group, e.g., a linear or branched C1-C4 alkyl group such as a methyl group, a haloalkyl group, a hydroxy group, an alkoxy group, e.g., a linear or branched C1-C4 alkoxy group such as a methoxy group, a mercapto group, an alkylthio group, a carboxy group, a sulfo group, an amino group, a N-substituted amino group, or a cyano group. In the repeating units (a1) to (a5), Ar groups may be the same as or different from each other.

Ar is preferably a phenylene group such as a p-phenylene group or a biphenylene group such as a 4,4'-biphenylene group.

An example of a resin containing the repeating unit (a1) is polyetherketone such as "PEEK-HT" available from Victrex. An example of a resin containing the repeating unit (a2) is polyetherketoneketone such as "PEKK" available from Arkema + Oxford Performance Materials. Examples of a resin containing the repeating unit (a3) include polyetheretherketone such as "VICTREX PEEK" available from Victrex, "Vestakeep®" available from Evonik, "Vestakeep-J" available from Daicel-Evonik, and "KetaSpire®" available from Solvay Specialty Polymers, and polyether-diphenylether-phenyl-ketone-phenyl such as "Kadel®" available from Solvay Specialty Polymers. An example of a resin containing the repeating unit (a4) is polyetherketoneetherketoneketone such as "VICTREX ST" available from Victrex. An example of a resin containing the repeating unit (a5) is polyetheretherketoneketone.

In the repeating unit containing an arylene group, an ether group, and a carbonyl group, the ratio (E/K) of an ether segment (E) to a ketone segment (K) may be, for example, 0.5 to 3.0, preferably about 0.5 to 2.0. The ether segment imparts flexibility to the molecule chain and the ketone segment imparts stiffness to the molecule chain. Thus, the larger the amount of the ether segment is, the higher the crystallization speed tends to be and the higher the crystallinity finally achieved tends to be, while the larger the amount of the ketone segment is, the higher the glass transition temperature tends to be and the higher the melting point tends to be.

One of these aromatic polyetherketone resins (I) may be used alone or two or more thereof may be used in combination.

Preferred among these aromatic polyetherketone resins (I) are aromatic polyetherketone resins containing any of the repeating units (a1) to (a4). For example, the aromatic polyetherketone resin (I) preferably includes at least one resin selected from the group consisting of polyetherketone, polyetheretherketone, polyetherketoneketone, and polyetherketoneetherketoneketone, more preferably at least one resin selected from the group consisting of polyetherketone, polyetheretherketone, and polyetherketoneketone. In order to achieve much better flexibility, much better bending resistance, and much lower dielectricity, polyetherketoneketone is particularly preferred.

The aromatic polyetherketone resin (I) preferably has a melting point of 300°C or higher, more preferably 320°C or higher. A melting point within this range allows the resulting film to have improved heat resistance. The melting point is preferably 380°C or lower. An aromatic polyetherketone resin having a melting point equal to or higher than 380°C may cause significant thermal degradation of the fluorine-containing copolymer during kneading, and thus, the physical properties may not be maintained.

The melting point is the temperature corresponding to the maximum value on a heat-of-fusion curve with a temperature-increasing rate of 10°C/min using a differential scanning calorimeter (DSC).

The aromatic polyetherketone resin (I) preferably has a melt flow rate (MFR), which is measured at 380°C and a 5000-g load, of 1 to 150 g/10 min, more preferably 5 to 130 g/10 min, still more preferably 10 to 100 g/10 min. A MFR within this range allows the resulting film to have much better tensile strength.

The MFR of the aromatic polyetherketone resin (I) is measured using a melt indexer in conformity with ASTM D1238.

The aromatic polyetherketone resin (I) preferably has a melt viscosity of 0.01 to 4.0 $kNsm^{-2}$ at 60 $sec^{-1}$ and 390°C. A melt viscosity within this range can lead to improved processability and allows the resulting film to have excellent tensile strength. The lower limit of the melt viscosity is preferably 0.05 $kNsm^{-2}$, more preferably 0.10 $kNsm^{-2}$, still more preferably 0.15 $kNsm^{-2}$. The upper limit of the melt viscosity is preferably 2.5 $kNsm^{-2}$, more preferably 1.5 $kNsm^{-2}$, still more preferably 1.0 $kNsm^{-2}$.

The melt viscosity of the aromatic polyetherketone resin (I) is measured in conformity with ASTM D3835-02.

The aromatic polyetherketone resin (I) preferably has a glass transition temperature of 130°C or higher, more preferably 135°C or higher, still more preferably 140°C or higher. A glass transition temperature within this range allows the resulting film to have excellent heat resistance. In terms of moldability, the upper limit of the glass transition temperature is preferably, but is not limited to, 220°C or lower, more preferably 180°C or lower.

The glass transition temperature is measured in conformity with JIS K7121 using a differential scanning calorimeter (DSC) at a temperature-increasing rate of 20°C/min.

(II) Fluorine-containing copolymer

In the film of the disclosure, the fluorine-containing copolymer (II) is, for example, a polymer containing at least one polymerized unit based on a fluorine-containing ethylenic monomer. The fluorine-containing copolymer (II) is preferably a melt-fabricable fluororesin. One fluorine-containing copolymer (II) may be used or two or more fluorine-containing copolymers (II) may be used.

Examples of the fluorine-containing copolymer (II) include a tetrafluoroethylene (TFE)/hexafluoropropylene (HFP) copolymer, a TFE/HFP/perfluoro(alkyl vinyl ether) (PAVE) copolymer, a TFE/PAVE copolymer (PFA), an ethylene (Et)/TFE copolymer, an Et/TFE/HFP copolymer, a chlorotrifluoroethylene (CTFE)/TFE copolymer, a CTFE/TFE/PAVE copolymer, an Et/CTFE copolymer, a TFE/vinylidene fluoride (VdF) copolymer, a VdF/HFP/TFE copolymer, and a VdF/HFP copolymer.

The PAVE preferably contains a C1-C6 alkyl group, and examples thereof include perfluoro(methyl vinyl ether), perfluoro(ethyl vinyl ether), perfluoro(propyl vinyl ether), and perfluoro(butyl vinyl ether).

The fluorine-containing copolymer (II) is more preferably a copolymer of tetrafluoroethylene (TFE) and a perfluoroethylenic unsaturated compound represented by the following formula (1):

$$CF_2=CF\text{-}Rf^1 \qquad (1)$$

wherein $Rf^1$ is $-CF_3$ or $-ORf^2$, where $Rf^2$ is a C1-C5 perfluoroalkyl group. When $Rf^1$ is $-ORf^2$, $Rf^2$ is preferably a C1-C3 perfluoroalkyl group. Use of the fluorine-containing copolymer (II) can lead to a film having excellent flexibility, excellent bending resistance, and excellently low dielectricity.

In order to provide a film having excellent flexibility, excellent bending resistance, and excellently low dielectricity, the perfluoroethylenic unsaturated compound represented by the formula (1) preferably includes at least one selected from the group consisting of hexafluoropropylene (HFP), perfluoro(methyl vinyl ether) (PMVE), perfluoro(ethyl vinyl ether) (PEVE), and perfluoro(propyl vinyl ether) (PPVE), more preferably at least one selected from the group consisting of hexafluoropropylene and perfluoro(propyl vinyl ether).

The fluorine-containing copolymer (II) preferably includes at least one selected from the group consisting of a TFE/HFP copolymer, a TFE/HFP/PPVE copolymer, and a TFE/PPVE copolymer, more preferably at least one selected from the group consisting of a TFE/HFP copolymer and a TFE/HFP/PPVE copolymer, and is particularly preferably a TFE/HFP/PPVE copolymer.

The fluorine-containing copolymer (II) preferably contains 98 to 75% by mass of a polymerized unit based on TFE (TFE unit) and 2 to 25% by mass of a polymerized unit based on a perfluoroethylenic unsaturated compound represented by the formula (1) relative to all polymerized units. The lower limit of the amount of TFE defining the fluorine-containing copolymer (II) is more preferably 77% by mass, still more preferably 80% by mass, particularly preferably 83% by mass, more particularly preferably 85% by mass. The upper limit of the amount of TFE defining the fluorine-containing copolymer (II) is more preferably 97% by mass, still more preferably 95% by mass, particularly preferably 92% by mass.

The lower limit of the amount of the perfluoroethylenic unsaturated compound represented by the formula (1) defining the fluorine-containing copolymer (II) is more preferably 3% by mass, still more preferably 5% by mass. The upper limit of the amount of the perfluoroethylenic unsaturated compound represented by the formula (1) defining the fluorine-containing copolymer (II) is more preferably 23% by mass, still more preferably 20% by mass, particularly preferably 17% by mass, more particularly preferably 15% by mass.

The fluorine-containing copolymer (II) is preferably a copolymer consisting of TFE and a perfluoroethylenic compound represented by the formula (1).

The fluorine-containing copolymer (II) preferably has a melt viscosity of 0.2 to 4.0 $kNsm^{-2}$ at 60 $sec^{-1}$ and 390°C. A melt viscosity within this range can lead to improved processibility and allows the resulting film to have excellent flexibility, excellent bending resistance, and excellently low dielectricity. The lower limit of the melt viscosity is more preferably 0.25 $kNsm^{-2}$, still more preferably 0.3 $kNsm^{-2}$, particularly preferably 0.35 $kNsm^{-2}$, most preferably 0.4 $kNsm^{-2}$. The upper limit of the melt viscosity is more preferably 3.7 $kNsm^{-2}$, still more preferably 3.6 $kNsm^{-2}$, particularly preferably 3.5 $kNsm^{-2}$.

The melt viscosity of the fluorine-containing copolymer (II) is measured in conformity with ASTM D3835-02.

The fluorine-containing copolymer (II) preferably has a melt flow rate (MFR), which is measured at 380°C and a 5000-g load, of 0.1 to 100 g/10 min, more preferably 0.5 to 80 g/10 min, still more preferably 0.5 to 70 g/10 min. An MFR within this range allows the resulting film to have excellent flexibility, excellent bending resistance, and excellently low dielectricity.

The MFR of the fluorine-containing copolymer (II) is measured using a melt indexer in conformity with ASTM D1238.

The melting point of the fluorine-containing copolymer (II) is preferably, but not limited to, equal to or lower than the melting point of the aromatic polyetherketone resin (I) because the fluorine-containing copolymer (II) has preferably already been in a molten state at a temperature where the aromatic polyetherketone resin (I) used in the molding melts. For example, the melting point of the fluorine-containing copolymer (II) is preferably 200°C to 323°C, more preferably 220°C to 320°C, still more preferably 240°C to 315°C. The melting point of the fluorine-containing copolymer (II) is determined as the temperature corresponding to the maximum value on a heat-of-fusion curve with a temperature-increasing rate of 10°C/min using a differential scanning calorimeter (DSC).

The fluorine-containing copolymer (II) may be treated with fluorine gas or ammonia by a known method in advance.

In order to reduce agglomeration and coalescence of the fluorine-containing copolymer phase and to easily control the rate of change of the dispersed particle size within a desired range in the film of the disclosure, a fluorine-containing copolymer containing a reactive functional group may be used. Specific examples of the reactive functional group include, but are not limited to, a vinyl group, an epoxy group, a carboxy group, an acid anhydride group, an ester group, an aldehyde group, a carbonyldioxy group, a haloformyl group, an alkoxycarbonyl group, an amino group, a hydroxy group, a styryl group, a methacrylic group, an acrylic group, a ureido group, a mercapto group, a sulfide group, an isocyanate group, and a hydrolyzable silyl group. Preferred among these is at least one selected from the group consisting of an epoxy group, a carboxy group, an acid anhydride group, an amino group, and a hydroxy group, more preferred is at least one selected from the group consisting of a carboxy group and an acid anhydride group. The fluorine-containing copolymer may contain two or more of these reactive functional groups. The reactive functional group(s) may be introduced into either a main chain end or a side chain of the fluorine-containing copolymer.

The functional group content in the fluorine-containing copolymer containing a reactive functional group is preferably, but not limited to, within a range from 0.01 mol% to 15 mol% in consideration of sufficient progress of the reaction and deterioration of the fluidity.

In the film of the disclosure, the aromatic polyetherketone resin (I) and the fluorine-containing copolymer (II) preferably have a melt viscosity ratio (I)/(II) (aromatic polyetherketone resin (I)/fluorine-containing copolymer (II)) of 0.01 to 5.0. A melt viscosity ratio (I)/(II) within this range allows the resulting film to have excellent flexibility, excellent bending resistance, and excellently low dielectricity. The lower limit of the melt viscosity ratio (I)/(II) is more preferably 0.02, still more preferably 0.025, particularly preferably 0.03. The upper limit of the melt viscosity ratio (I)/(II) is more preferably 4.0, still more preferably 3.0, particularly preferably 2.5, more particularly preferably 2.0, most preferably 1.8.

In the film of the disclosure, the mass ratio (I) : (II) between the aromatic polyetherketone resin (I) and the fluorine-containing copolymer (II) is preferably, but not limited to, 99:1 to 30:70, for example. The mass ratio is more preferably 95:5 to 35:65, still more preferably 95:5 to 40:60.

The film of the disclosure preferably has a tensile modulus of 2400 MPa or lower. The tensile modulus is more preferably 2350 MPa or lower, still more preferably 2000 MPa or lower, particularly preferably 1800 MPa or lower, most preferably 1700 MPa or lower.

The tensile modulus is a value measured in conformity with ASTM D638.

The film of the disclosure preferably has a fold number of 2000 times or more determined using an MIT folding tester. The fold number is more preferably 3000 times or more, still more preferably 3500 times or more, particularly preferably 4000 times or more.

The fold number is a value determined in conformity with ASTM D2176.

The film of the disclosure preferably has a relative permittivity of 2.80 or lower, more preferably 2.70 or lower, still more preferably 2.60 or lower. A relative permittivity lower than this range allows the film to be suitably used as a wrapping electric wire coating material or a film for a flexible printed circuit board. The lower limit of the relative permittivity is more preferably, but not limited to, 2.30 or higher. In the case where the proportion of the fluorine-containing copolymer is high such that the relative permittivity is approximately lower than 2.30, the resulting mechanical properties are significantly poor and desired mechanical properties are difficult to achieve.

The relative permittivity is a value measured by a cavity resonator perturbation method.

The film of the disclosure may further contain an optional component other than the aromatic polyetherketone resin (I) and the fluorine-containing copolymer (II). Examples of the optional component other than the aromatic polyetherketone resin (I) and the fluorine-containing copolymer (II) include, but are not limited to, fibrous reinforcements such as whiskers of, e.g., potassium titanate, glass fiber, asbestos fiber, carbon fiber, ceramic fiber, potassium titanate fiber, aramid fiber, and other high-strength fibers; inorganic fillers such as talc, mica, clay, carbon powder, graphite, artificial graphite, natural graphite, and glass beads; colorants; commonly used inorganic or organic fillers such as flame retarders; lubricants such as silicone oil and molybdenum disulfide; pigments; conducting agents such as carbon black; impact resistance improvers such as rubber; glidants such as magnesium stearate; ultraviolet absorbers such as benzotriazole compounds; foaming agents such as boron nitride; and other additives.

These additives in amounts that do not impair the effects of the disclosure may be added to the aromatic polyetherketone resin (I) that serves as a material or to the fluorine-containing copolymer (II) that serves as a material. Also, these additives in amounts that do not impair the effects of the disclosure may be added to the materials in a molten state in, for example, a side feeding manner upon kneading of the aromatic polyetherketone resin (I) and the fluorine-containing copolymer (II).

(III) Fibrous filler

The film of the disclosure may further contain a fibrous filler (III). Examples of the fibrous filler used in the film of the disclosure include fibrous inorganic fillers such as glass fiber, carbon fiber, carbon milled fiber, metal fiber, asbestos, rock wool, ceramic fiber, slag fiber, potassium titanate whisker, boron whisker, aluminum borate whisker, calcium carbonate whisker, titanium oxide whisker, wollastonite, xonotlite, palygorskite (attapulgite), and sepiolite; heat-resistant fibrous organic fillers typified by heat-resistant organic fibers, such as aramid fiber, polyimide fiber, and polybenzothiazole fiber; and fibrous fillers prepared by coating the surfaces of these fillers with a different material such as a metal or a metal oxide. Examples of the fillers prepared by coating the surfaces of the listed fillers with a different material include metal-coated glass fiber and metal-coated carbon fiber. Examples of methods for coating the surfaces with a different material include, but are not limited to, known plating processes such as electrolytic plating, electroless plating, and melt plating; vacuum deposition; ion plating; CVD processes such as thermal CVD, MOCVD, and plasma CVD; a PVD process; and sputtering. Preferred among these fibrous fillers is at least one selected from the group consisting of glass fiber, carbon fiber, carbon milled fiber, and aramid fiber, more preferred is at least one selected from the group consisting of glass fiber and carbon fiber.

The fibrous filler (III) preferably has a fiber diameter ranging from 0.1 to 20 um. The upper limit of the fiber diameter is more preferably 18 um, still more preferably 15 um. The lower limit of the fiber diameter is more preferably 1 um, still more preferably 6 um. The fiber diameter refers to the number average fiber diameter. The number average fiber diameter is a value calculated from scanning electron microscopic images of residues collected after the molded article is dissolved in a solvent or after the resin is decomposed with a basic compound and ash residues collected after the molded article is burned into ashes in a crucible.

In the case where the fibrous filler used in the film of the disclosure is glass fiber, the glass fiber may have any of a variety of glass compositions such as compositions of A-glass, C-glass, and E-glass. Such glass filler may optionally contain components such as $TiO_2$, $SO_3$, and $P_2O_5$. More preferred among these is E-glass (alkali-free glass). The glass fiber is preferably surface-treated with a known surface-treating agent such as a silane coupling agent, a titanate coupling agent, or an aluminate coupling agent in order to achieve improved mechanical strength. Also, the glass fiber is preferably bundled with a resin such as an olefinic resin, a styrenic resin, an acrylic resin, a polyester resin, an epoxy resin, or a urethane resin, particularly preferably with an epoxy resin or a urethane resin in order to achieve increased mechanical strength. The amount of a sizing agent attached to the bundled glass fiber is preferably 0.1 to 3% by mass, more preferably 0.2 to 1% by mass in 100% by mass of the glass fiber. The fibrous filler used in the film of the disclosure may be glass fiber having a flat cross section. For the glass fiber having a flat cross section, the fiber cross section preferably has an average major axis of 10 to 50 um, more preferably 15 to 40 um, still more preferably 20 to 35 um, and preferably has an average ratio of the major axis to the minor axis (major axis/minor axis) of 1.5 to 8, more preferably 2 to 6, still more preferably 2.5 to 5. Use of a glass fiber having a flat cross section with an average ratio of the major axis to the minor axis falling within this range leads to greater improvement in anisotropy than use of fiber having a non-circular cross section with an average ratio of lower than 1.5. Examples of the shape of the flat cross section include not only a flat shape but also an elliptical shape, an eye-brow shape, a trefoil shape, and a non-circular shape similar to any of these shapes. In order to improve mechanical strength and low anisotropy, a flat shape is preferred among these. The glass fiber having a flat cross section preferably has a ratio between the average fiber length and the average fiber diameter (aspect ratio) of 2 to 120, more preferably 2.5 to 70, still more preferably 3 to 50. A ratio between the fiber length and the average fiber diameter of lower than 2 may cause a poor effect of improving the mechanical strength. A ratio between the fiber length and the average fiber diameter of higher than 120 may cause a high anisotropy and poor appearance of the molded article. The average fiber diameter of the glass fiber having a flat cross section refers to the number average fiber diameter obtained when the flat cross-sectional shape is converted into a true circular shape having the same area as the flat cross-sectional shape. The average fiber length refers to the number average fiber length of the fiber in the film of the disclosure. The number average fiber length is a value calculated using an image analyzer from optical microscopic images of filler residues collected after the molded article is subjected to treatment such as ashing at high temperature, dissolution in a solvent, or decomposition with a chemical. The value is calculated without counting the fibers having a length not longer than the fiber diameter.

The fibrous filler (III) is preferably present in a mass proportion of 0 to 50% by mass, more preferably 5 to 40% by mass, still more preferably 10 to 30% by mass relative to the film of the disclosure.

(Other additives)

In order to improve the design, for example, of the film of the disclosure, any of additives are advantageously used. These additives are described in detail below.

(IV) Dye and pigment

The film of the disclosure may further contain any of a variety of dyes and pigments to provide a molded article exhibiting any of a variety of design. Examples of dyes and pigments to be used in the film of the disclosure include perylene-based dyes, coumarin-based dyes, thioindigo-based dyes, anthraquinone-based dyes, thioxanthone-based dyes, ferrocyanides such as Prussian blue, perinone-based dyes, quinoline-based dyes, quinacridone-based dyes, dioxazine-based dyes, isoindolinone-based dyes, and phthalocyanine-based dyes. The film of the disclosure may further contain a metallic pigment to achieve better metallic color. A preferred metallic pigment is aluminum powder. Mixing a fluorescent brightener or a different light-emitting fluorescent dye can provide a better design effect utilizing the luminescent color.

(V) Heat-absorptive compound

The film of the disclosure may contain a heat-absorptive compound. Preferred examples of this compound include various metal compounds having an excellent near-infrared light absorbing ability such as a phthalocyanine-based near-infrared absorber, a metal oxide-based near-infrared absorber, e.g. ATO, ITO, iridium oxide, ruthenium oxide, imonium oxide, and titanium oxide, and a metal boride-based or tungsten oxide-based near-infrared absorber such as lanthanum boride, cerium boride, and tungsten boride; and carbon filler. An example of the phthalocyanine-based near-infrared absorber is MIR-362, which is commercially available from Mitsui Chemicals, Inc. and is easily available. Examples of the carbon filler include carbon black, graphite (including both natural and artificial), and fullerene. Preferred are carbon black and graphite. One of these may be used alone or two or more thereof may be used in combination. The phthalocyanine-based near-infrared absorber is preferably contained in an amount of 0.0005 to 0.2 parts by mass, more preferably 0.0008 to 0.1 parts by mass, still more preferably 0.001 to 0.07 parts by mass relative to 100 parts by mass of the film of the disclosure. The metal oxide-based near-infrared absorber, metal boride-based near-infrared absorber, and carbon filler are each preferably contained in an amount within a range from 0.1 to 200 ppm (proportion by mass), more preferably 0.5 to 100 ppm, in the film of the disclosure.

(VI) Highly light-reflective white pigment

The film of the disclosure may contain a highly light-reflective white pigment to achieve a light-reflecting effect. The white pigment is particularly preferably a titanium dioxide pigment, especially titanium dioxide treated with an organic surface-treating agent such as silicone. The highly light-reflective white pigment is preferably contained in an amount of 3 to 30 parts by mass, more preferably 8 to 25 parts by mass, relative to 100 parts by mass of the resin composition. Two or more highly light-reflective white pigments may be used in combination.

(VII) Ultraviolet absorber

The film of the disclosure may contain an ultraviolet absorber to achieve weather resistance. Specific examples of the ultraviolet absorber include benzophenone-based ultraviolet absorbers such as 2,4-dihydroxybenzophenone, 2-hydroxy-4-methoxybenzophenone, 2-hydroxy-4-octoxybenzophenone, 2-hydroxy-4-benzyloxybenzophenone, 2-hydroxy-4-methoxy-5-sulfoxybenzophenone, 2,2'-dihydroxy-4-methoxybenzophenone, 2,2',4,4'-tetrahydroxybenzophenone, 2,2'-dihydroxy-4,4'-dimethoxybenzophenone, 2,2'-dihydroxy-4,4'-dimethoxy-5-sodiumsulfoxybenzophenone, bis(5-benzoyl-4-hydroxy-2-methoxyphenyl)methane, 2-hydroxy-4-n-dodecyloxybenzophenone, and 2-hydroxy-4-methoxy-2'-carboxybenzophenone. Specific examples of the ultraviolet absorber include benzotriazole-based ultraviolet absorbers such as 2-(2-hydroxy-5-methylphenyl)benzotriazole, 2-(2-hydroxy-5-tert-octylphenyl)benzotriazole, 2-(2-hydroxy-3,5-dicumylphenyl)phenylbenzotriazole, 2-(2-hydroxy-3-tert-butyl-5-methylphenyl)-5-chlorobenzotriazole, 2,2'-methylenebis[4-(1,1,3,3-tetramethylbutyl)-6-(2H-benzotriazol-2-yl)phenol], 2-(2-hydroxy-3,5-di-tert-butylphenyl)benzotriazole, 2-(2-hydroxy-3,5-di-tert-butylphenyl)-5-chlorobenzotriazole, 2-(2-hydroxy-3,5-di-tert-amylphenyl)benzotriazole, 2-(2-hydroxy-5-tert-octylphenyl)benzotriazole, 2-(2-hydroxy-5-tert-butylphenyl)benzotriazole, 2-(2-hydroxy-4-octoxyphenyl)benzotriazole, 2,2'-methylenebis(4-cumyl-6-benzotriazolephenyl), 2,2'-p-phenylenebis(1,3-benzoxazin-4-one), and 2-[2-hydroxy-3-(3,4,5,6-tetrahydrophthalimidomethyl)-5-methylphenyl]benzotriazole, and polymers having a 2-hydroxyphenyl-2H-benzotriazole skeleton such as a copolymer of 2-(2'-hydroxy-5-methacryloxyethylphenyl)-2H-benzotriazole and a vinyl monomer copolymerizable with the former monomer and a copolymer of 2-(2'-hydroxy-5-acryloxyethylphenyl)-2H-benzotriazole and a vinyl monomer copolymerizable with the former monomer. Specific examples of the ultraviolet absorber include hydroxyphenyltriazine-based ultraviolet absorbers such as 2-(4,6-diphenyl-1,3,5-triazin-2-yl)-5-hexyloxyphenol, 2-(4,6-diphenyl-1,3,5-triazin-2-yl)-5-methyloxyphenol, 2-(4,6-diphenyl-1,3,5-triazin-2-yl)-5-ethyloxyphenol, 2-(4,6-diphenyl-1,3,5-triazin-2-yl)-5-propyloxyphenol, and 2-(4,6-diphenyl-1,3,5-triazin-2-yl)-5-butyloxyphenol. Examples thereof also include compounds obtainable by replacing the phenyl group in any of the aforementioned compounds by a 2,4-dimethylphenyl group, such as 2-(4,6-bis(2,4-dimethylphenyl)-1,3,5-triazin-2-yl)-5-hexyloxyphenol. Specific examples of the ultraviolet absorber include cyclic imino ester-based ultraviolet absorbers such as 2,2'-p-phenylenebis(3,1-benzoxazin-4-one), 2,2'-m-phenylenebis(3,1-benzoxazin-4-one), and 2,2'-p,p'-diphenylenebis(3,1-benzoxazin-4-one). Specific examples of the ultraviolet absorber also include cyanoacrylate-based ultraviolet absorbers such as 1,3-bis-[(2'-cyano-3',3'-diphenylacryloyl)oxy]-2,2-bis[(2-cyano-3,3-diphenylacryloyl)oxy]methyl)propane and 1,3-bis-[(2-cyano-3,3-diphenylacryloyl)oxy]benzene. The ultraviolet absorber may be a polymer-form ultraviolet absorber that is in the form of a copolymer of an ultraviolet absorptive monomer and/or a light-stable monomer with a monomer such as an alkyl (meth)acrylate as a result of having a structure of a radically polymerizable monomer compound. Preferred examples of the ultraviolet absorptive monomer include compounds containing a benzotriazole skeleton, a benzophenone skeleton, a triazine skeleton, a cyclic imino ester skeleton, or a cyanoacrylate skeleton in an ester substituent of a (meth)acrylic acid ester. In view of the ultraviolet absorbing ability, preferred among these are benzotriazole-based ultraviolet absorbers and hydroxyphenyltriazine-based ultraviolet absorbers. In view of the heat resistance and hue, preferred are cyclic imino ester-based ultraviolet absorbers and cyanoacrylate-based ultraviolet absorbers. Specific examples thereof include "Kemisorb 79" available from Chemipro Kasei Kaisha, Ltd. and "Tinuvin 234" available from BASF Japan Ltd. One of these ultraviolet absorbers may be used alone or two or more thereof may be used in the form of a mixture.

The ultraviolet absorber is preferably contained in an amount of 0.01 to 3 parts by mass, more preferably 0.01 to 1 part by mass, still more preferably 0.05 to 1 part by mass, particularly preferably 0.05 to 0.5 parts by mass, relative to 100 parts by mass of the film of the disclosure.

(VIII) Antistatic agent

The film of the disclosure may be required to have antistatic performance in some cases. In such cases, the film of the disclosure preferably contains an antistatic agent. Examples of the antistatic agent include (1) phosphonium organosulfonates such as phosphonium arylsulfonates, typified by phosphonium dodecylbenzenesulfonate, and phosphonium alkylsulfonates; and phosphonium borates such as phosphonium tetrafluoroborate. The phosphonium salt is appropriately contained in an amount of 5 parts by mass or less, preferably ranging from 0.05 to 5 parts by mass, more preferably from 1 to 3.5 parts by mass, still more preferably from 1.5 to 3 parts by mass, relative to 100 parts by mass of the film of the disclosure. Examples of the antistatic agent include (2) organosulfonic acid alkali (alkaline earth) metal salts such as lithium organosulfonates, sodium organosulfonates, potassium organosulfonates, caesium organosulfonates, rubidium organosulfonates, calcium organosulfonates, magnesium organosulfonates, and barium organosulfonates. These metal salts can also be used as flame retarders, as described above. Specific examples of the metal salts include metal salts of dodecylbenzenesulfonic acid and metal salts of perfluoroalkanesulfonic acids. The organosulfonic acid alkali (alkaline earth) metal salt is appropriately contained in an amount of 0.5 parts by mass or less, preferably 0.001 to 0.3 parts by mass, more preferably 0.005 to 0.2 parts by mass, relative to 100 parts by mass of the film of the disclosure. Particularly preferred are salts of alkali metals such as potassium, caesium, and rubidium.

Examples of the antistatic agent include (3) ammonium organosulfonates such as ammonium alkylsulfonates and ammonium arylsulfonates. The ammonium salt is appropriately contained in an amount of 0.05 parts by mass or less relative to 100 parts by mass of the film of the disclosure. Examples of the antistatic agent include (4) polymers containing a poly(oxyalkylene) glycol component as a constituent, such as polyether ester amide. The polymer is appropriately contained in an amount of 5 parts by mass or less relative to 100 parts by mass of the film of the disclosure.

(IX) Filler

The film of the disclosure may contain any of a variety of known fillers as reinforcing filler other than fibrous fillers. Examples of such fillers include a variety of platy filler and powdery filler. The platy filler means filler in the form of plates, including those having a rough surface and those having a curved portion. The powdery filler means filler having a shape other than these shapes, including filler having an indefinite shape.

Preferred examples of the platy filler include glass flakes, talc, mica, kaolin, metal flakes, carbon flakes, and graphite, and platy filler prepared by coating the surface of any of these fillers with a different material such as a metal or a metal oxide. The particle size thereof preferably ranges from 0.1 to 300 um. For filler having a particle size within a range up to about 10 um, the particle size corresponds to the median size (D50) in the particle size distribution determined by X-ray transmission, which is one of liquid sedimentation techniques. For filler having a particle size within a range of 10 to 50 um, the particle size corresponds to the median size (D50) in the particle size distribution determined by laser diffraction/scattering. For filler having a particle size within a range of 50 to 300 um, the particle size corresponds to the particle size determined by vibration sieving. The particle size is the value in the resin composition. The platy filler may be surface-treated with any of a variety of coupling agents such as silane coupling agents, titanate coupling agents, aluminate coupling agents, and zirconate coupling agents. Alternatively, the platy filler may be a granulated product prepared by bundling the platy filler with any of a variety of resins such as olefinic resin, styrenic resin, acrylic resin, polyester resin, epoxy resin, and urethane resin or a higher fatty acid ester or by compressing the platy filler.

(X) Different resin and/or elastomer

The film of the disclosure may contain a small proportion of a different resin and/or elastomer instead of a portion of the resin component to the extent that the effects of the disclosure are not impaired and can be achieved. The different resin and/or elastomer is preferably contained in an amount of 20 parts by mass or less, more preferably 10 parts by mass or less, still more preferably 5 parts by mass or less, most preferably 3 parts by mass or less, relative to 100 parts by mass of the film of the disclosure. Examples of the different resin include resins such as polyester resins, including polyethylene terephthalate and polybutylene terephthalate, polyamide resin, polyimide resin, polyetherimide resin, polyurethane resin, silicone resin, polyphenylene ether resin, polyphenylene sulfide resin, polysulfone resin, polymethacrylate resin, phenol resin, and epoxy resin. Examples of the different elastomer include isobutylene-isoprene rubber, styrene-butadiene rubber, ethylenepropylene rubber, acrylic elastomers, polyester elastomers, polyamide elastomers, and core-shell elastomers such as methyl methacrylate-styrene-butadiene (MBS) rubber, methyl methacrylate-butadiene (MB) rubber, and methyl methacrylate-acrylonitrile-styrene (MAS) rubber, fluororubber, and a fluorine-containing elastomer.

(XI) Other additives

The film of the disclosure may contain any of additives such as an antioxidant, a fluidity improver, an antibacterial agent, a dispersant such as a liquid paraffin, a light-catalytic soil resistant agent, and a photochromic agent.

In the film of the disclosure, the sum of the aromatic polyetherketone resin (I) and the fluorine-containing copolymer (II) is preferably 50 to 100% by mass. Less than 50% by mass in total of these components may cause the absence of flexibility and bending resistance and may cause a failure in providing desired mechanical properties.

The thickness of the film of the disclosure may be set as appropriate in accordance with, for example, the target use, and is commonly 0.001 to 1 mm. In terms of easy handling, the thickness of the film is preferably 0.01 mm or greater, more preferably 0.05 mm or greater, while preferably 0.7 mm or smaller, more preferably 0.5 mm or smaller.

The film of the disclosure has excellent flexibility, excellent bending resistance, and excellently low dielectricity, and also has excellent heat resistance, excellent chemical resistance, excellent solvent resistance, excellent strength, excellent slidability, excellent rigidity, excellently low chemical permeability, excellent dimensional stability, excellent incombustibility, excellent electric properties, and excellent durability. Thus, the film can be used for a variety of applications. For example, the film is suitable for a wrapping electric wire coating material, a flexible printed circuit board and its surface protective layer, a surface cover layer of a multi-chip package, a variety of mechanical parts, a sliding part, a mechanism part, a sliding part in the field of automobiles, a protective layer for a circuit board of an aerospace system, a liner of a chemical plant, a fuel cell part, a part of an energy generator, a heat insulating plate, a sealant, an actuator, a tubular part or sealing tape for drilling of energy source such as petroleum, natural gas, or shale oil, a release film, and insulating paper such as a variety of adhesive tape for electric insulation.

The disclosure also relates to a wrapping electric wire coating material including the film of the disclosure. The wrapping electric wire coating material is a coating material for wrapping an electric wire, and this coating material of an electric wire may be commonly formed by wrapping a band-shaped film around a core wire and heating the workpiece. The wrapping electric wire coating material may include a single layer of the film of the disclosure, may include two or more layers of the film of the disclosure, or may include one or more layers of the film of the disclosure and one or more layers of a film other than the film of the disclosure.

The disclosure also relates to a film for a flexible printed circuit board including the film of the disclosure. The flexible printed circuit board refers to what is called a flexible printed circuit (FPC). The flexible printed circuit board needs to have not only low dielectricity but also flexibility and bending resistance. Conventional FPCs are formed from a polyester film or a polyimide film, but are not satisfactory in terms of water absorption and hydrolyzability. The film of the disclosure has all of flexibility, bending resistance, and low dielectricity, as well as low water absorption and low hydrolyzability, and thus is particularly useful as a film for a flexible printed circuit board. The film for a flexible printed circuit board may include a single layer of the film of the disclosure, may include two or more layers of the film of the disclosure, or may include one or more layers of the film of the disclosure and one or more layers of a film other than the film of the disclosure.

The disclosure also relates to a laminate including the film of the disclosure. The laminate of the disclosure includes at least one layer of the film of the disclosure, and has a structure including two or more layers stacked therein.

Embodiments of the laminate of the disclosure include the following: a laminate including two or more layers of the film of the disclosure and not including any layer other than the layers of the film of the disclosure; a laminate including one or more layers of the film of the disclosure and one or more layers other than the layers of the film of the disclosure; and a laminate including one or more layers of the film of the disclosure and one or more layers of copper, stainless steel, aluminum, iron, an alloy of any of these, or carbon fiber, for example. The number of layers may be, but is not limited to, 10 layers or less or may be 5 layers or less.

Examples of the laminate of the disclosure include a flexible printed circuit board, a wrapping electric wire coating material, CFRTP, a part relating to computers, a part relating to hard discs, and a part relating to semiconductor manufacturing process.

The film of the disclosure may be treated by, for example, Na etching, alkali treatment, plasma treatment, corona discharge treatment, irradiation, or flame treatment for surface modification. The surface modification may be performed once or twice, or more times. Any of these treatments can lead to improved hydrophilicity on the film surface, improved printability, and improved adhesiveness to a different material.

EXAMPLES

The disclosure is described with reference to, but not limited to, examples.

<Melt flow rate (MFR)>

(1) The MFR of the fluorine-containing copolymer (II) is measured using a melt indexer at 380°C and a 5000-g load in conformity with ASTM D1238.
(2) The MFR of the aromatic polyetherketone resin (I) is measured using a melt indexer at 380°C and a 5000-g load in conformity with ASTM D1238.
(3) The MFR of the film obtained by mixing the fluorine-containing copolymer (II) and the aromatic polyetherketone resin (I) is a value measured at 380°C and a 5000-g load and with a preheating time of five minutes in conformity with ASTM D1238.

<Melting point>

The melting point of the fluorine-containing copolymer (II) was determined as the temperature corresponding to the maximum value on a heat-of-fusion curve with a temperature-increasing rate of 10°C/min using a differential scanning calorimeter (DSC).
The melting point of the aromatic polyetherketone resin (I) was determined as the temperature corresponding to the maximum value on a heat-of-fusion curve with a temperature-increasing rate of 10°C/min using a differential scanning calorimeter (DSC).

<Glass transition temperature (Tg)>

The glass transition temperature (Tg) is measured using a differential scanning calorimeter (DSC).

<Shear rate during kneading>

The shear rate ($\gamma$) during kneading was determined using the following formula.

$$\gamma = \pi Dr/C$$

D: screw outer diameter (mm)
r: screw rotation speed (rps)
C: tip clearance (mm)

<Crystallinity>

The crystallinity was obtained as follows. First, the wide angle X-ray diffraction was determined at an output of 40 kV-40 mA and a scanning angle ranging from 5 to 40 degrees using an X-ray diffractometer. Next, the peak area derived from the crystal of the aromatic polyetherketone resin (I) and the whole peak area were calculated. The crystallinity was then determined by the following formula.
Crystallinity (%) = 100 × (peak area derived from crystal of aromatic polyetherketone resin (I))/(whole peak area)
The whole peak area is the area obtained by integrating all diffraction intensities measured at scanning angles ranging from 5 to 40 degrees (excluding the peak area derived from the crystal of the fluorine-containing copolymer (II)).
The peak area derived from the crystal of the aromatic polyetherketone resin (I) is the sum of the areas of the peaks derived from the crystal of the aromatic polyetherketone resin (I).
The peak area derived from the crystal of the fluorine-containing copolymer (II) is the area of the peak observed around $2\Theta$ = 17.7 degrees.
The peak area derived from the crystal of PEEK used in the examples is the sum of the areas of the peaks observed around $2\Theta$ = 15.7 degrees, 18.5 degrees, 20.4 degrees, 22.7 degrees, and 28.5 degrees. The peak observed around $2\Theta$ = 15.7 degrees is presumed to be a peak derived from the (020) plane. The peak observed around $2\Theta$ = 18.5 degrees is presumed to be a peak derived from the (110) plane. The peak observed around $2\Theta$ = 20.4 degrees is presumed to be a peak derived from the (111) plane. The peak observed around $2\Theta$ = 22.7 degrees is presumed to be a peak derived from the (200) plane. The peak observed around 2Θ = 28.5 degrees is presumed to be a peak derived from the (211) plane.

The peak area derived from the crystal of PEEK is the sum of the areas of the peaks observed around 2Θ = 18.7 degrees, 20.4 degrees, 22.3 degrees, and 28.6 degrees. The peak observed around 2Θ = 18.7 degrees is presumed to be a peak derived from the (110) plane. The peak observed around 2Θ = 20.4 degrees is presumed to be a peak derived from the (111) plane. The peak observed around 2Θ = 22.3 degrees is presumed to be a peak derived from the (200) plane. The peak observed around 2Θ = 28.6 degrees is presumed to be a peak derived from the (211) plane.

<Tensile modulus and tensile elongation (tensile elongation at break)>

The films obtained in the examples were each punched in the MD direction using an ASTM Type V dumbbell to provide a dumbbell-shaped specimen having a gauge length of 7.6 mm. The resulting dumbbell-shaped specimen was used to determine the tensile modulus (MPa) and the tensile elongation (%) at a temperature of 25°C, a chuck-to-chuck distance of 24.5 mm, and a tensile rate of 50 mm/min in conformity with ASTM D638.

<Fold number determined using MIT folding tester>

The 100-pm-thick films obtained were each cut to provide a strip having a width of 1.5 cm and a length of 110 mm, whereby a sample was obtained. This was mounted on an MIT type folding endurance tester (available from Yasuda Seiki Seisakusho Ltd.) and subjected to a repeated folding test under conditions in conformity with ASTM D-2176 (load: 12.25 N, folding angle: 135 degrees, 175 times/min). The number of folds until break was counted.

<Average dispersed particle size and maximum dispersed particle size>

The films obtained were each cut in the direction perpendicular to the extrusion direction, and the cross section was observed using a confocal laser microscope. The resulting micrograph was analyzed using image analysis software (Image J). The dispersed phases were selected and the equivalent circle diameters were measured. The equivalent circle diameters of 20 dispersed phases are calculated and averaged to determine the average dispersed particle size.

<Ratio of average dispersed particle sizes>

Each of the films obtained was used to determine the average dispersed particle size $r_2$ of the fluorine-containing copolymer (II) after melt flow rate measurement at 380°C and a 5000-g load with 5-minute pre-heating in conformity with ASTM D1238. The ratio $r_2/r_1$ was then determined, wherein $r_1$ represents the average dispersed particle size before the measurement.

The resin compositions produced in the examples were each dried at 120°C for eight hours and injection-molded using a small injection molding machine, whereby a specimen in conformity with JIS K7161-2 was obtained.

<Relative permittivity>

The aforementioned injection-molded article was cut using a waterjet available from Omax Corp. to provide a specimen (1.5 × 1.5 × 8.0 cm). The relative permittivity at 6 GHz of the cut-out specimen was measured by a cavity resonance perturbation method (using a network analyzer).

In the examples, the following materials were used.

Aromatic polyetherketone resin (1):
polyetherketoneketone (MFR: 31 g/10 min, melting point: 331°C, Tg: 162°C)
Aromatic polyetherketone resin (2):
polyetherketoneketone (MFR: 41 g/10 min, melting point: 331°C, Tg: 160°C)
Aromatic polyetherketone resin (3):
polyetheretherketone (MFR: 75.6 g/10 min, melting point: 343°C, Tg: 149°C)
Aromatic polyetherketone resin (4):
polyetherketoneketone (trade name Cypek® grade DS, available from Cytec Fiberite Inc., MFR: 40 g/10 min, melting point: 336°C, Tg: 159°C, crystallization temperature (Tcc): 217°C)
Aromatic polyetherketone resin (5):
polyetherketoneketone (trade name Cypek® grade HT, available from Cytec Fiberite Inc., MFR: 25 g/10 min, melting point: 351°C, Tg: 158°C, Tcc: 200°C)
Fluorine-containing copolymer (1): TFE/HFP/PPVE copolymer, MFR: 29.8 g/10 min, melting point: 260°C

Fluorine-containing copolymer (2): TFE/HFP/PPVE copolymer, MFR: 12.3 g/10 min, melting point: 255°C
Fluorine-containing copolymer (3): perfluoroalkoxy resin Teflon® PFA340, melting point: 305°C, available from Du Pont-Mitsui Fluorochemicals Co., Ltd.
Fluorine-containing copolymer (4): fluorinated ethylene propylene resin Teflon® FEP, melting point: 260°C, available from Du Pont-Mitsui Fluorochemicals Co., Ltd.

Examples 1 to 9

The aromatic polyetherketone resin (I) and the fluorine-containing copolymer (II) were dry-blended in the ratio (% by mass) shown in Table 1 and dried at 120°C for eight hours. The dried mixture was melt-kneaded using a reflux high shear processor available from Niigata Machine Techno Co., Ltd. under the following predetermined conditions. The return hole used had a diameter of 2.5 mm.

Screw L/D: 1.8
Kneading temperature: 370°C
Shear rate during kneading: 870 sec$^{-1}$
Kneading duration: 10 seconds

The kneaded products obtained and the aromatic polyetherketone resin (I) alone (Example 12) were each fed to a film-forming T-die extruder and molded into a 100-pm-thick film under conditions including a cylinder temperature of 380°C, a die temperature of 380°C, and a screw rotation speed of 7 rpm, as well as a colling roll temperature condition shown in Table 1. In this process, the extruded film was in contact with the cooling roll for 1 to 10 seconds. Then, the films of Examples 6 to 9 were subjected to crystallization treatment under the respective annealing conditions shown in Table 1. Specifically, the molded film was sandwiched between 300 mm × 210 mm molds and annealed in an oven at 180°C for three hours. The resulting films were subjected to a variety of evaluation. The results are shown in Table 1.

Example 10

Polyetherketoneketone (trade name Cypek® grade DS, available from Cytec Fiberite Inc., MFR: 40 g/10 min, melting point: 336°C, Tg: 159°C, Tcc: 217°C) and perfluoroalkoxy resin Teflon® PFA340 (melting point: 305°C, available from Du Pont-Mitsui Fluorochemicals Co., Ltd.) were dry blended at 80:20 (% by mass), and the dry blend was fed as a material to a 50-mm vented single screw extruder (Ikegai Corp.). The material was melted at 370°C and extruded through a 500-mm-wide slit die (gap 0.8 mm) so that it was cast on a 10°C roll. The casting was such that the material was electrostatically brought into a close contact with the roll, followed by cooling. Thereby, a film having a thickness of about 100 um was obtained.
The resulting film was cut to provide a specimen, which was used to determine the average dispersed particle sizes before and after MFR measurement as in Examples 1 to 9. The particle size before the MFR measurement (r1) was 5.2 um, while the particle size after the MFR measurement (r2) was 9.8 um. The particle size ratio (r2/r1) was 1.9.

Example 11

Polyetherketoneketone (trade name Cypek® grade HT, available from Cytec Fiberite Inc., MFR: 25 g/10 min, melting point: 351°C, Tg: 158°C, Tcc: 200°C) and a fluorinated ethylene propylene resin (Teflon® FEP, melting point: 260°C, available from Du Pont-Mitsui Fluorochemicals Co., Ltd.) were dry blended at 80:20 (% by mass), and the dry blend was used as a material to provide a film in the same manner as in Example 10.
The resulting film was cut to provide a specimen, which was used to determine the average dispersed particle sizes before and after MFR measurement as in Examples 1 to 9. The particle size before the MFR measurement (r1) was 5.4 um, while the particle size after the MFR measurement (r2) was 10.3 um. The particle size ratio (r2/r1) was 1.9.

[Table 1]

| Resin | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|
| Aromatic polyetherketone resin (1) (parts by mass) | | 80 | 60 | | | | 80 | 60 | | | | | 100 |
| Aromatic polyetherketone resin (2) (parts by mass) | | | | 50 | | | | | | | | | |
| Aromatic polyetherketone resin (3) (parts by mass) | | | | | 50 | 40 | | | 50 | 40 | | | |
| Aromatic polyetherketone resin (4) (parts by mass) | | | | | | | | | | | 80 | | |
| Aromatic polyetherketone resin (5) (parts by mass) | | | | | | | | | | | | 80 | |
| Fluorine-containing copolymer (1) (parts by mass) | | 20 | 40 | 50 | | | 20 | 40 | | | | | |
| Fluorine-containing copolymer (2) (parts by mass) | | | | | 50 | 60 | | | 50 | 60 | | | |
| Fluorine-containing copolymer (3) (parts by mass) | | | | | | | | | | | 20 | | |
| Fluorine-containing copolymer (4) (parts by mass) | | | | | | | | | | | | 20 | |
| Cooling roll temperature | Annealing condition | | | | | | | | | | | | |
| 25°C | 0 Hours (no annealing) | | | | ○ | ○ | | | | | | | |
| 160°C | 0 Hours (no annealing) | ○ | ○ | ○ | | | | | | | ○ | ○ | ○ |
| | 3 Hours | | | | | | ○ | ○ | ○ | ○ | | | |

18

(continued)

| Resin | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|
| Crystallinity (%) | 0 | 0 | 0 | 4 | 5 | 11 | 6 | 21 | 25 | 0 | 0 | 0 |
| Tensile modulus (MPa) | 2312 | 1926 | 1693 | 1714 | 1628 | 2880 | 2351 | 2387 | 2149 | 2450 | 2500 | 2732 |
| Tensile elongation (%) | 97 | 80 | 89 | 92 | 75 | 62 | 80 | 85 | 70 | 43 | 32 | 28 |
| Fold number (times) | 4419 | 3639 | 3837 | 4012 | 3857 | 1932 | 1758 | 38 | 27 | 90 | 41 | 548 |
| Average dispersed particle size ($\mu$m) | 0.18 | 0.28 | 0.22 | 0.86 | 1.17 | 0.18 | 0.28 | 0.86 | 1.17 | 5.2 | 5.4 | - |
| Average dispersed particle size ratio | 1.1 | 1.25 | 1.23 | 1.32 | 1.52 | 1.1 | 1.25 | 1.32 | 1.52 | 1.9 | 1.9 | - |
| Maximum dispersed particle size ($\mu$m) | 0.4 | 0.7 | 0.7 | 0.8 | 0.8 | 0.4 | 0.7 | 0.8 | 0.8 | 112 | 10.6 | - |
| Relative permittivity | 2.7 | 2.5 | 2.4 | 2.6 | 2.5 | 2.7 | 2.5 | 2.6 | 2.5 | 2.7 | 27 | 3 |

**Claims**

1. A film comprising:

   a resin composition comprising an aromatic polyetherketone resin (I) and a fluorine-containing copolymer (II),
   the fluorine-containing copolymer (II) defining a dispersed phase at an average dispersed particle size of 5.0 um or smaller,
   the aromatic polyetherketone resin (I) having a crystallinity of lower than 6%.

2. The film according to claim 1,
   wherein the film satisfies a ratio r2/r1 of 1.60 or lower, wherein r1 represents the average dispersed particle size of the fluorine-containing copolymer (II) and r2 represents an average dispersed particle size of the fluorine-containing copolymer (II) after melt flow rate measurement at 380°C and a 5000-g load with 5-minute pre-heating in conformity with ASTM D1238.

3. A film comprising:

   a resin composition comprising an aromatic polyetherketone resin (I) and a fluorine-containing copolymer (II),
   the film satisfying a ratio r2/r1 of 1.60 or lower,

   wherein r1 represents an average dispersed particle size of the fluorine-containing copolymer (II) and r2 represents an average dispersed particle size of the fluorine-containing copolymer (II) after melt flow rate measurement at 380°C and a 5000-g load with 5-minute pre-heating in conformity with ASTM D1238.

4. The film according to any one of claims 1 to 3,
   wherein the film has a tensile modulus of 2400 MPa or lower.

5. The film according to any one of claims 1 to 4,
   wherein the film has a fold number of 2000 times or more determined using an MIT folding tester.

6. The film according to any one of claims 1 to 5,
   wherein the aromatic polyetherketone resin (I) has a melting point of 300°C to 380°C.

7. The film according to any one of claims 1 to 6,
   wherein the aromatic polyetherketone resin (I) has a glass transition temperature of 130°C to 220°C.

8. The film according to any one of claims 1 to 7,
   wherein the fluorine-containing copolymer (II) has a melting point of 200°C to 323°C.

9. The film according to any one of claims 1 to 8,
   wherein the fluorine-containing copolymer (II) is a copolymer of tetrafluoroethylene and a perfluoroethylenic unsaturated compound represented by the following formula (1) :

   $$CF_2=CF\text{-}Rf^1 \qquad (1)$$

   wherein $Rf^1$ is $\text{-}CF_3$ or $\text{-}ORf^2$, where $Rf^2$ is a C1-C5 perfluoroalkyl group.

10. The film according to any one of claims 1 to 9,
    wherein the aromatic polyetherketone resin (I) and the fluorine-containing copolymer (II) have a mass ratio (I):(II) of 99:1 to 30:70.

11. A wrapping electric wire coating material comprising the film according to any one of claims 1 to 10.

12. A film for a flexible printed circuit board, comprising the film according to any one of claims 1 to 10.

13. A laminate comprising the film according to any one of claims 1 to 10.

## INTERNATIONAL SEARCH REPORT

| International application No. |
| --- |
| **PCT/JP2021/028459** |

| A. | CLASSIFICATION OF SUBJECT MATTER |
| --- | --- |

*C08J 5/18*(2006.01)i; *C08L 27/12*(2006.01)i; *C08L 71/10*(2006.01)i; *H01B 3/42*(2006.01)i; *H05K 1/03*(2006.01)i
FI:   C08J5/18 CEZ; C08L27/12; H01B3/42 G; H05K1/03 670Z; C08L71/10

According to International Patent Classification (IPC) or to both national classification and IPC

| B. | FIELDS SEARCHED |
| --- | --- |

Minimum documentation searched (classification system followed by classification symbols)

C08J5/00-5/02; C08J5/12-5/22; C08K3/00-13/08; C08L1/00-101/14; H01B3/42; H05K1/03

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2019-183175 A (DAIKIN INDUSTRIES, LTD.) 24 October 2019 (2019-10-24) claims 1-2, paragraphs [0024], [0042], [0061], [0114], examples | 1-10, 13 |
| Y | | 1-13 |
| Y | JP 2016-079391 A (DAIKIN INDUSTRIES, LTD.) 16 May 2016 (2016-05-16) claims 3-4, 10, paragraphs [0063], [0069], [0084], examples | 1-13 |

☐ Further documents are listed in the continuation of Box C.      ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **05 October 2021** | **19 October 2021** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2021/028459**

| Patent document cited in search report | | | Publication date (day/month/year) | Patent family member(s) | Publication date (day/month/year) |
|---|---|---|---|---|---|
| JP | 2019-183175 | A | 24 October 2019 | (Family: none) | |
| JP | 2016-079391 | A | 16 May 2016 | US 2017/0301430 A1<br>claims 3-4, 10, paragraphs<br>[0100], [0108], [0124],<br>examples<br>EP 3214134 A1<br>KR 10-2017-0049573 A<br>CN 106795368 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016029164 A
- JP 2003082123 A
- JP 2006274073 A
- WO 2019198771 A
- JP 2005313608 A
- JP 2011046103 A